# EUROPÄISCHE PATENTSCHRIFT

(11) **EP 3 995 837 B1**
(45) Veröffentlichungstag und Bekanntmachung des Hinweises auf die Patenterteilung: **06.12.2023**
(21) Anmeldenummer: 21203762.6
(22) Anmeldetag: 20.10.2021
(51) Int. Cl.: G01R 1/20, G01R 31/364

(54) **WIDERSTANDSBAUGRUPPE UND BATTERIESENSOR MIT WIDERSTANDSBAUGRUPPE**
RESISTOR ASSEMBLY AND BATTERY SENSOR WITH RESISTOR ASSEMBLY
MODULE DE RÉSISTANCE ET CAPTEUR DE BATTERIE POURVU DE MODULE DE RÉSISTANCE

(30) Priorität: 10.11.2020 DE 102020214083
(43) Veröffentlichungstag der Anmeldung: 11.05.2022
(73) Patentinhaber: Continental Automotive Technologies GmbH, 30165 Hannover (DE)
(72) Erfinder: Frenzel, Henryk, 60488 Frankfurt am Main (DE); Schramme, Martin, 60488 Frankfurt am Main (DE); Aumer, Andreas, 60488 Frankfurt am Main (DE)
(74) Vertreter: Continental Corporation

(56) Entgegenhaltungen:
- EP-A1- 0 718 633
- DE-A1-102010 031 113
- DE-A1-102013 005 939
- DE-A1-102015 218 795
- DE-A1-102018 217 557
- DE-U1-202006 015 500
- FR-A1- 3 039 329
- US-A1- 2013 181 807
- US-A1- 2017 307 658
- US-A1- 2018 156 844
- US-A1- 2018 328 996
- US-A1- 2020 182 936
- US-B2- 10 161 966
- US-B2- 10 613 147

## Beschreibung

Die Erfindung betrifft eine Widerstandsbaugruppe für einen Batteriesensor in einem Fahrzeug, mit zwei Leitungsabschnitten, einem zwischen den Leitungsabschnitten angeordneten Messwiderstand, wobei der Messwiderstand an Kontaktflächen elektrisch leitend mit den Leitungsabschnitten verbunden ist. Die Erfindung betrifft des Weiteren einen Batteriesensor mit einer solchen Widerstandsbaugruppe.

In vielen Anwendungen, insbesondere im Fahrzeugbereich, ist es erforderlich, die auftretenden Ströme sehr exakt zu ermitteln bzw. zu messen. Aus dem Stand der Technik sind beispielsweise Verfahren sowie Batteriesensoren bekannt, bei welchen die Stromstärke über den Spannungsabfall über einen im Strompfad angeordneten Messwiderstand ermittelt wird. Der elektrische Widerstand des Messwiderstandes ist sehr genau bekannt oder kann ermittelt werden. Aus dem erfassten Spannungsabfall sowie dem bekannten elektrischen Widerstand kann über das ohmsche Gesetz der über den Messwiderstand fließende Strom, also der Batteriestrom berechnet werden.

In der DE 20 2006 015 500 U1 ist beispielsweise eine Anordnung mit einem Messwiderstand gezeigt, wobei der Messwiderstand einen Zapfen aufweist, mit dem der Messwiderstand in ein als Batterieklemme ausgebildetes Anschlusselement geschoben wird.

US 10 613 147 B2 ist eine Messanordnung gezeigt, bei der der Messwiderstand aus mehreren dünnen Schichten besteht.

In der US 2020/182936 A1 ist eine Messanordnung gezeigt, bei der der Messwiderstand aus zwei ineinandergreifenden Verbindungselementen besteht.

In der US 2018/328996 A1 ist ein Batteriesensor gezeigt, der auf jeder Seite des Messwiderstandes mehrere Messkontakte aufweist, um verschiedene Messwerte zu erfassen.

In der DE 10 2018 217 557 A1, der DE 10 2010 031 113A1 und der US 10 161 966 B2, der EP 0 7189 633 A1 und der US 2017/307658 A1 sind weitere Messanordnung mit jeweils rechteckigen Messwiderständen gezeigt.

Üblicherweise werden für den Messwiderstand spezielle Legierungen verwendet, beispielsweise eine Kupfer-Nickel-Mangan-Legierung, die einen geringeren Widerstands-Temperaturkoeffizienten, also eine geringe Empfindlichkeit bei Temperaturänderungen, aufweisen, so dass der elektrische Wiederstand sehr genau bestimmt werden kann.

Die Leitungsabschnitte bestehen üblicherweise aus einer Kupferlegierung mit einem geringen elektrischen Widerstand und sind mit dem Messwiderstand verschweißt.

Die verwendeten Kupferlegierungen für die Leitungsabschnitte haben eine höhere Temperaturabhängigkeit des elektrischen Widerstandes, also einen hohen Widerstands-Temperaturkoeffizient.

Die Messkontakte sind üblicherweise auf den Leitungsabschnitten angeordnet, sodass sich der elektrische Gesamtwiderstand aus dem elektrischen Widerstand des Messwiderstandes des sowie den elektrischen Widerständen der Leitungsabschnitte zwischen den Messkontakten zusammensetzt.

Aufgrund der höheren Temperaturabhängigkeit des elektrischen Widerstandes der Leitungsabschnitte beeinflussen diese den elektrischen Gesamtwiderstand und somit die Genauigkeit der Messung.

Das Verhalten des elektrischen Widerstandes des Messwiderstandes und der Leitungsabschnitte bei verschiedenen Temperaturen ist bekannt, sodass bei bekannter Temperatur der genaue elektrische Widerstand bestimmt werden kann. Zur Bestimmung der Temperatur ist aber ein zusätzlicher Temperatursensor erforderlich.

Insgesamt ist aber eine geringe Temperaturabhängigkeit des elektrischen Gesamtwiderstandes erwünscht, um eine möglichst genaue Messung zu ermöglichen.

Aufgabe der Erfindung ist es, eine Widerstandsbaugruppe für einen Batteriesensor in einem Fahrzeug bereitzustellen, der eine genauere Messung des Batteriestroms ermöglicht. Aufgabe der Erfindung ist es des Weiteren einen Batteriesensor mit einer solchen Widerstandsbaugruppe bereitzustellen.

Zur Lösung der Aufgabe ist eine Widerstandsbaugruppe für einen Batteriesensor in einem Fahrzeug vorgesehen, mit zwei Leitungsabschnitten, einem zwischen den Leitungsabschnitten angeordneten Messwiderstand und einer Spannungserfassungseinrichtung zur Erfassung eines Spannungsabfalls über den Messwiderstand, wobei der Messwiderstand an Kontaktflächen elektrisch leitend mit den Leitungsabschnitten verbunden ist. Die Kontaktflächen sind zur Längsachse des Messwiderstandes geneigt, so dass der Messwiderstand schräg zur Hauptstromrichtung der Widerstandsbaugruppe angeordnet ist, die durch die Längsachse der Leitungsabschnitte bzw. der Widerstandsbaugruppe definiert ist. Dadurch ist die Strecke des Messwiderstandes in Richtung der Hauptstromrichtung, die durch die Längsrichtung des Messwiderstandes sowie der angrenzenden Leitungsabschnitte definiert ist, größer als schräg zur Hauptstromrichtung, insbesondere senkrecht zu einer der Kontaktflächen. Dies führt zu einem geänderten Stromfluss bzw. zu geänderten Potentiallinien innerhalb des Messwiderstandes und der angrenzenden Bereiche der Leitungsabschnitt. Dadurch kann die Temperaturabhängigkeit des elektrischen Widerstandes zwischen den Messkontakten positiv beeinflusst werden, insbesondere reduziert werden, da der temperaturbedingte Einfluss der Leitungsabschnitte geringer ausfällt. Am ersten Leitungsabschnitt sind zumindest ein erster Kontaktpunkt und am zweiten Leitungsabschnitt zumindest ein dem ersten Kontaktpunkt zugeordneter zweiter Kontaktpunkt vorgesehen. Der erste Kontaktpunkt und der zugeordnete zweite Kontaktpunkt sind quer zur Längsrichtung des Messwiderstandes so angeordnet, dass der Einfluss einer temperaturbedingten Änderung des elektrischen Widerstandes des Messwiderstandes und/oder der Leitungsabschnitte reduziert und/oder kompensiert ist.

Insbesondere können die Kontaktflächen auch zu den Längsachsen der Leitungsabschnitte im Bereich der Kontaktflächen geneigt sein.

Die Leitungsabschnitte bzw. deren Längsachsen können insbesondere in Abhängigkeit von den Einbaubedingungen gewählt werden. Beispielsweise können die Längsachse des Messwiderstandes und die Längsachse zumindest eines Leitungsabschnittes übereinstimmen. Das heißt, die der Messwiderstand und die Leitungsabschnitte bilden ein längliches Bauteil, das einfach herzustellen ist.

Üblicherweise wird zur Herstellung der bisher bekannten Widerstandsbaugruppen ein flächiges Grundmaterial für die Leitungsabschnitte bereitgestellt, in das ein Streifen aus einem Widerstandsmaterial eingearbeitet ist. Dieses Grundmaterial kann beispielsweise vorgefertigt als Bandmaterial, Rollenware oder in Form von Blechen angeliefert werden. Aus diesem Grundmaterial werden rechtwinklig zur Längsrichtung Streifen abgetrennt, die jeweils eine Widerstandsbaugruppe bilden. Die vorstehend beschriebenen Widerstandsbaugruppen können ebenfalls aus diesem flächigen Grundmaterial ausgestanzt werden, indem die Schnittkanten schräg zu Längsrichtung des Bandmaterials gesetzt werden. Es ist also keine Herstellung eines neuen Grundmaterials erforderlich. Es ist lediglich eine Änderung der Schnittkanten erforderlich.

Vorzugsweise verlaufen die Kontaktflächen im Wesentlichen parallel zueinander, sodass der Messwiderstand im Wesentlichen parallelogrammartig ausgebildet ist. Dadurch ist eine einfache Herstellung der Widerstandsbaugruppe möglich. Zudem kann das Verhalten des Stromflusses bzw. der Potentiallinien einfache abgeschätzt werden.

Die Positionen der Kontaktpunkte können verschieden gewählt werden. Vorzugsweise werden die Positionen so gewählt, dass zwischen den Kontaktpunkten ein optimaler Gesamt-Widerstands-Temperaturkoeffizient, also eine möglichst geringe Temperaturabhängigkeit des elektrischen Gesamtwiderstandes, bereitgestellt wird. Ein erster Kontaktpunkt und der zugeordnete zweiter Kontaktpunkt können dazu beispielsweise quer zur Längsrichtung des Messwiderstandes versetzt angeordnet sein. Beispielsweise kann zumindest ein Kontaktpunkte beabstandet von einer Mittellinie beziehungsweise einer Symmetrieachse der Widerstandsbaugruppe angeordnet sein.

Des Weiteren kann auch der Abstand der Kontaktpunkte zum Messwiderstand unterschiedlich sein und in Abhängigkeit von einem gewünschten Gesamt-Widerstands-Temperaturkoeffizient gewählt werden.

Es können auch mehrere erste Kontaktpunkte und jeweils zugeordnete zweite Kontaktpunkte vorgesehen sein. Durch die ungleiche Stromverteilung und die ungleichen Potentiallinien im Messwiderstand und den angrenzenden Bereichen der Leitungsabschnitten ergeben sich für die verschiedenen Paare von ersten und zweiten Kontaktpunkten verschieden elektrische Widerstände. Insbesondere kann der temperaturbedingte Einfluss auf die elektrischen Widerstände aufgrund der unterschiedlichen Position der Kontaktpunkte variieren. Eine temperaturbedingte Änderung des elektrischen Widerstandes wirkt sich also unterschiedlich auf die Gesamtwiderstände zwischen den ersten Kontaktpunkten und den jeweils zugeordneten zweiten Kontaktpunkten aus. Da aber die Temperatur der Widerstandsbaugruppe für alle Gesamtwiderstände gleich ist, können die unterschiedlichen elektrischen Gesamtwiderstände zur Berechnung einer temperaturbedingten Änderung der Gesamtwiderstände und somit zur Kompensation der temperaturbedingten Änderungen der Gesamtwiderstände genutzt werden.

Zur Lösung der Aufgabe ist des Weiteren ein Batteriesensor zur Erfassung eines Batteriestroms vorgesehen, mit einer vorstehend beschriebenen Widerstandsbaugruppe und mit einer Erfassungseinrichtung zur Erfassung eines Spannungsabfalls über dem Messwiderstand, insbesondere zwischen zumindest einem ersten Kontaktpunkt und einem zugeordneten zweiten Kontaktpunkt.

Weitere Vorteile und Merkmale ergeben sich aus der nachfolgenden Beschreibung in Verbindung mit den beigefügten Zeichnungen. In diesen zeigen:
- Figur 1: einen Batteriesensor;
- Figur 2: eine Widerstandsbaugruppe für den Batteriesensor aus Figur 1;
- Figur 3: die Stromverteilung in der Widerstandsbaugruppe aus Figur 2; und
- Figur 4: die Herstellung der Widerstandsbaugruppe aus Figur 2 aus einem Grundmaterial.

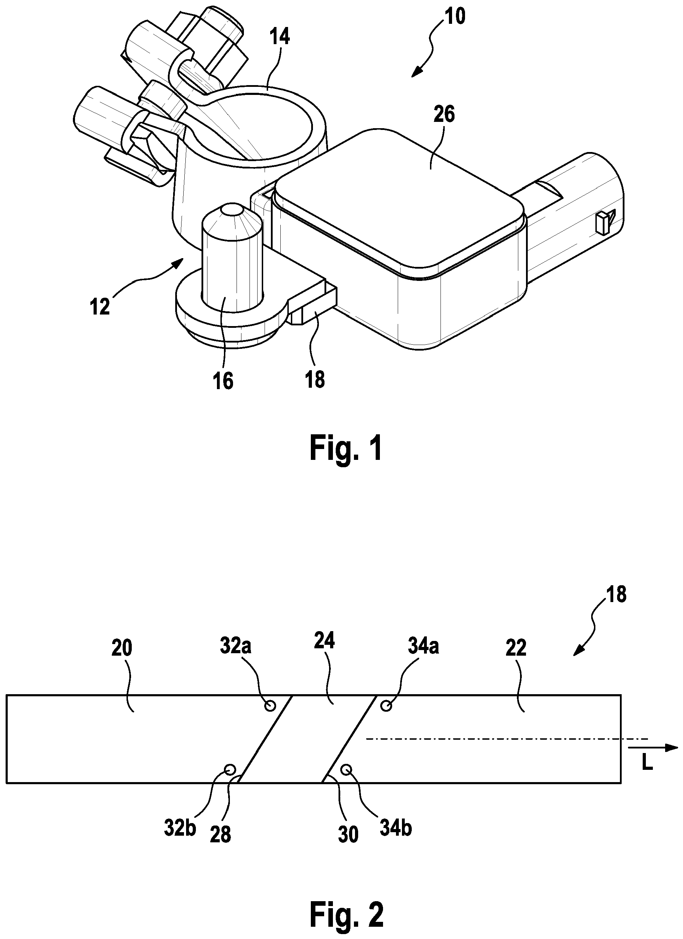

In Figur 1 ist ein Batteriesensor 10 gezeigt. Der Batteriesensor 10 hat eine Verbindungsbaugruppe 12 bestehend aus einer Batteriepolklemme 14, einen Kabelanschluss 16 sowie einer Widerstandsbaugruppe 18, die die Batteriepolklemme 14 und den Kabelanschluss 16 elektrisch miteinander verbindet. Die Widerstandsbaugruppe 18 besteht aus zwei Leitungsabschnitten 20, 22, zwischen welchen ein Messwiderstand 24 vorgesehen ist.

Der Batteriesensor 10 weist des Weiteren eine Spannungserfassungseinrichtungen 26 auf, die mit der Widerstandsbaugruppe 18 bezüglich einer Stromrichtung vor und hinter dem Messwiderstand 24 elektrisch verbunden ist und einen Spannungsabfall über den Messwiderstand 24 erfassen kann. Aus dem erfassten Spannungsabfall über den Messwiderstand 24 und dem bekannten elektrischen Widerstand des Messwiderstandes 24 kann über das ohmsche Gesetz der über den Messwiderstand 24, also über den Batteriesensor 10, fließende Strom berechnet werden.

Der Messwiderstand 24 besteht üblicherweise aus einem Material, das sowohl über die Lebensdauer wie auch bei Temperaturunterschieden einen möglichst gleichbleibenden elektrischen Widerstand aufweist. Beispielsweise wird eine Kupfer-Nickel-Mangan-Legierung verwendet. Die Batteriepolklemme 14 der Kabelanschluss 16 sowie die Leitungsabschnitte 20, 22 werden aus einem Material mit sehr guter elektrischer Leitfähigkeit hergestellt, beispielsweise Kupfer oder einer Kupferlegierung.

Die Verbindung des für den Messwiderstand 24 verwendeten Materials, beispielsweise der Kupfer-Nickel-Mangan-Legierung, ist aber sehr aufwendig. Aus diesem Grund wird eine Widerstandsbaugruppe 18 bereitgestellt, die neben dem Messwiderstand 24 zwei Leitungsabschnitte 20, 22 aufweist, die aus einem elektrisch leitenden Material bestehen. Diese Abschnitte 20, 22 können auf einfache Weise mit der Batteriepolklemme 14 und dem Kabelanschluss 16 verbunden werden. Insbesondere können die Leitungsabschnitte 20, 22 aus dem gleichen oder einem ähnlichen Material bestehen wie die Batteriepolklemme 14 und der Kabelanschluss 16, sodass diese auf einfache Weise, beispielsweise durch Löten oder Schweißen, verbunden werden können.

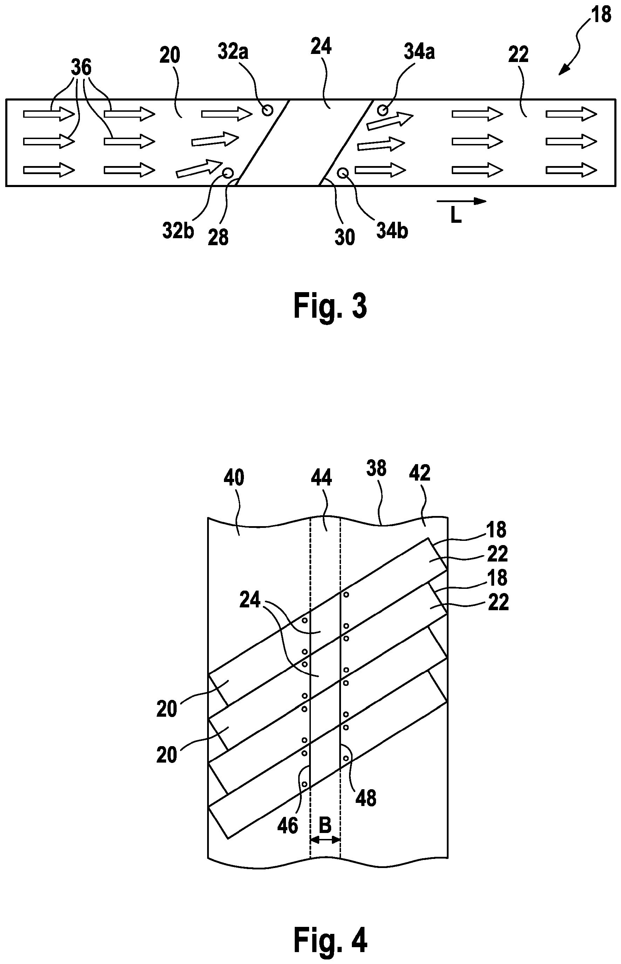

Die Widerstandsbaugruppe 18 ist in den Figuren 2 und 3 im Detail dargestellt. Wie in Figur 2 zu sehen ist, ist die Widerstandsbaugruppe 18 im Wesentlichen länglich und rechteckig ausgebildet wobei der Messwiderstand 24 im wesentlichen parallelogrammartig ausgebildet und jeweils mit einer Kontaktfläche 28, 30 mit den Leitungsabschnitten 20, 22 verbunden ist. Dadurch sind die Kontaktflächen 28, 30 jeweils zur Längsrichtung des Messwiderstandes 24, die der Längsrichtung L der Widerstandsbaugruppe 18 entspricht, schräg bzw. geneigt ausgebildet.

Auf dem ersten Leitungsabschnitt 20 sind zwei erste Kontaktpunkte 32a, 32b vorgesehen. Auf dem zweiten Leitungsabschnitt 22 sind zwei jeweils zu den ersten Kontaktpunkten 32a, 32b zugeordnete zweite Kontaktpunkte 34a, 34b vorgesehen. Die Spannungserfassungseinrichtung 26 ist jeweils dazu ausgebildet den Spannungsabfall zwischen einem ersten Kontaktpunkte 32a bzw. 32b und dem zugeordneten zweiten Kontaktpunkte 34a bzw. 34b zu erfassen.

Der elektrische Gesamtwiderstand zwischen einem ersten Kontaktpunkte 32a, 32b und dem korrespondierenden zweiten Kontaktpunkte 34a, 34b ergibt sich hierbei aus einem Teil der elektrischen Widerstände der Leitungsabschnitte 20,22 sowie dem elektrischen Widerstand des Messwiderstand des 24 zwischen dem ersten Kontaktpunkte 32a, 32b und dem korrespondierenden zweiten Kontaktpunkte 34a, 34b.

Die Position der Kontaktpunkte 32a, 32b, 34a, 34b quer zu Längsrichtung der Leitungsabschnitte 20, 22 bzw. der Widerstandsbaugruppe 18 sowie deren Abstand zum Messwiderstand 24 kann, wie nachfolgend im Detail erläutert wird, variiert werden.

Wie insbesondere in Figur 3 zu sehen ist, ergibt sich aufgrund der unterschiedlichen elektrischen Widerstände der Leitungsabschnitte 20, 22 sowie des Messwiderstand 24 eine gegenüber einem herkömmlichen rechteckigen Messwiderstand eine veränderte Stromverteilung.

Aufgrund des geringeren elektrischen Widerstands der Leitungsabschnitte 20,22 ergibt sich eine Konzentration der Potentiallinien 36 für die Kontaktpunkte 32a bzw. 34b. Dies führt auch dazu, dass die Potentiallinien 36 nicht in Längsrichtung L durch den Messwiderstand 24 verlaufen bzw. der Stromfluss nicht in Längsrichtung L durch den Messwiderstand 24 strömt, sondern schräg zu diesen.

Da der Strom üblicherweise den Weg des geringsten Widerstands sucht, wird dieser im Inneren des Messwiderstandes 24 weitgehend senkrecht zu den Kontaktflächen 28, 30 fließen. Damit ergibt sich eine reduzierte Stromdichte im Bereich der spitzen Winkel des Messwiderstands 24 und eine höhere Stromdichte im restlichen Bereich der Kontaktflächen 28, 30. Dem Stromvektor wird also eine Komponente parallel zu den Kontaktflächen 28, 30 aufgezwungen. Steigt der elektrische Widerstand der Leitungsabschnitte 20, 22 an, beispielsweise durch eine Temperaturänderung, erhöht sich der elektrische Widerstand für den Stromvektor parallel zu den Kontaktflächen 28, 30 und somit der elektrische Gesamtwiderstand. Es wird also für den Strom ungünstiger, einen längeren Weg parallel zu den Kontaktflächen 28, 30 in Kauf zu nehmen. Ein Strompfad mit einem längeren Weg, insbesondere einem schrägen Weg durch den Messwiderstand 24 aber dafür kürzeren Abschnitten in den Leitungsabschnitten 28, 30 kann dadurch einen kleinere elektrischen Gesamtwiderstand aufweisen. Der Strom kann also bei steigender Temperatur dem zunehmenden elektrischen Widerstand der Leitungsabschnitte "ausweichen" und der Temperaturkoeffizient der gesamten Anordnung wird geringer.

Die geänderten Potentiallinien bzw. der geänderte Stromfluss führt unter anderem dazu, dass der Einfluss einer temperaturbedingten Änderung des elektrischen Widerstandes der Leitungsabschnitte 20, 22 geringer wird sodass insgesamt eine genauere Messung des durch den Batteriesensor bzw. die Widerstandsbaugruppe 18 fließenden Stroms möglich ist.

Insbesondere können die ersten Kontaktpunkte 32a, 32b und die korrespondierenden zweiten Kontaktpunkte 34a, 34b so angeordnet sein, dass eine temperaturbedingte Änderung des elektrischen Widerstandes der Leitungsabschnitte 20, 22 unterschiedlichen Einfluss auf die Messung des Spannungsabfalls zwischen den ersten Kontaktpunkten 32a, 32b und den korrespondierenden zweiten Kontaktpunkten 34a, 34b hat. Dies kann beispielsweise dadurch erfolgen, dass die Messstrecke zwischen einem ersten Kontaktpunkt 32a, 32b und dem korrespondierenden zweiten Kontaktpunkt 34a, 34b unterschiedlich lang ist und/oder einen größeren Anteil der Leitungsabschnitte 20,22 beinhaltet. Alternativ oder ergänzend kann dies auch durch die Position der Kontaktpunkte 32a, 32b, 34a, 34b erfolgen.

Durch die unterschiedlichen Messungen lassen sich temperaturbedingte Änderungen der Messergebnisse bestimmen und/oder korrigieren.

Die Widerstandsbaugruppe 18 wird beispielsweise aus einem flächiges Grundmaterial 38 hergestellt (Figur 4). Das flächige Grundmaterial 38 besteht aus drei Abschnitten, einem ersten Abschnitt 40 aus einem elektrisch leitenden Material, einem zweiten Abschnitt 42 aus einem elektrisch leitenden Material sowie einem zwischen dem ersten Abschnitt 40 und dem zweiten Abschnitt 42 verlaufenden Widerstandsabschnitt 44, der aus einem Widerstandsmaterial, beispielsweise einer Kupfer-Nickel-Mangan-Legierung, besteht.

Der Widerstandsabschnitt 44 hat eine konstante Breite B und wird durch zwei gegenüberliegende Ränder 46, 48 begrenzt. Die Ränder 46, 48 verlaufen somit parallel zueinander. Der erste Abschnitt 40 ist am ersten Rand 46, der zweite Abschnitt 42 am zweiten Rand 48 elektrisch leitend sowie mechanisch mit dem Widerstandsabschnitt 44 verbunden. Das Grundmaterial 38 kann beispielsweise als Endlosmaterial, beispielsweise aufgerollt, angeliefert werden.

Üblicherweise werden von diesem Grundmaterial 38 senkrecht zur Längsrichtung Streifen abgetrennt, wobei der erste Abschnitt den ersten Leitungsabschnitt 12, der zweite Abschnitt 30 den zweiten Leitungsabschnitt 16 und der Widerstandsabschnitt 32 den Messwiderstand 20 bilden.

Zur Herstellung der Widerstandsbaugruppe 18 werden nunmehr Streifen schräg zu Längsrichtung des Grundmaterials 38 abgetrennt, wodurch sich eine längliche Widerstandsbaugruppe 18 mit einem schräg eingesetzten Messwiderstand 24 ergibt, dessen Kontaktflächen zu den Leitungsabschnitten 20, 22 schräg ausgebildet sind. Die Herstellung der Widerstandsbaugruppe 18 kann somit auf einfache Weise aus dem bisher verwendeten Grundmaterial 38 erfolgen.

In dem vorstehend beschriebenen Ausführungsbeispiel ist der Messwiderstand aus einer Kupfer-Nickel-Mangan-Legierung hergestellt. Es ist aber auch möglich, dass zur Herstellung des Messwiderstandes andere Materialien insbesondere auch Materialien mit einer größeren Temperaturabhängigkeit des elektrischen Widerstandes verwendet werden können.

## Patentansprüche

1. Widerstandsbaugruppe (18) für einen Batteriesensor (10) in einem Fahrzeug, mit zwei Leitungsabschnitten (20, 22) und einem zwischen den Leitungsabschnitten (20, 22) angeordneten Messwiderstand (24), wobei der Messwiderstand (24) an Kontaktflächen (28, 30) elektrisch leitend mit den Leitungsabschnitten (20, 22) verbunden ist, **dadurch gekennzeichnet, dass** die Kontaktflächen (28, 30) zu der Längsachse (L) der Widerstandsbaugruppe (18) schräg sind, so dass der Messwiderstand (24) schräg zur Hauptstromrichtung der Widerstandsbaugruppe (18) angeordnet ist, die durch die Längsachse der Leitungsabschnitte bzw. der Widerstandsbaugruppe definiert ist, dass am ersten Leitungsabschnitt (20) zumindest ein erster Kontaktpunkt (32a, 32b) und am zweiten Leitungsabschnitt (22) zumindest ein dem ersten Kontaktpunkt (32a, 32b) zugeordneter zweiter Kontaktpunkt (34a, 34b) vorgesehen ist, wobei der erste Kontaktpunkt (32a, 32b) und der zugeordnete zweite Kontaktpunkt (34a, 34b) quer zur Längsrichtung (L) der Widerstandsbaugruppe (18) so angeordnet sind, dass der Einfluss einer temperaturbedingten Änderung des elektrischen Widerstandes des Messwiderstandes (24) und/oder der Leitungsabschnitte (20, 22) reduziert und/oder kompensiert ist.

2. Widerstandsbaugruppe nach Anspruch 1, **dadurch gekennzeichnet, dass** die Kontaktflächen (28, 30) zu den Längsachsen der Leitungsabschnitte (20, 22) schräg sind.

3. Widerstandsbaugruppe nach einem der Ansprüche 1 und 2, **dadurch gekennzeichnet, dass** die die Längsachse des Messwiderstandes (24) und die Längsachse zumindest eines Leitungsabschnittes (20, 22) übereinstimmen.

4. Widerstandsbaugruppe nach einem der vorhergehenden Ansprüche, **dadurch gekennzeichnet, dass** die Kontaktflächen (28, 30) im Wesentlichen parallel zueinander verlaufen.

5. Widerstandsbaugruppe nach einem der vorhergehenden Ansprüche, **dadurch gekennzeichnet, dass** ein erster Kontaktpunkt (32a, 32b) und ein dem ersten Kontaktpunkt (32a, 32b) zugeordneter zweiter Kontaktpunkt (34a, 34b) quer zur Längsrichtung (L) der Widerstandsbaugruppe (18) versetzt angeordnet sind.

6. Widerstandsbaugruppe nach einem der vorhergehenden Ansprüche, **dadurch gekennzeichnet, dass** zumindest zwei erste Kontaktpunkte (32a, 32b) und zumindest zwei zweite Kontaktpunkte (34a, 34b) vorgesehen sind, wobei jedem ersten Kontaktpunkt (32a, 32b) ein zweiter Kontaktpunkt (34a, 34b) zugeordnet ist.

7. Widerstandsbaugruppe nach Anspruch 6, **dadurch gekennzeichnet, dass** die Positionen der ersten Kontaktpunkte (32a, 32b) und/oder der zweiten Kontaktpunkte (34a, 34b) quer zur Längsachse (L) der Widerstandsbaugruppe (18) und/oder der Abstand der ersten Kontaktpunkte (32a, 32b) und/oder der zweiten Kontaktpunkte (34a, 34b) zum Messwiderstand variieren kann.

8. Batteriesensor (10) zur Erfassung eines Batteriestroms, mit einer Widerstandsbaugruppe (18) nach einem der vorhergehenden Ansprüche und mit einer Erfassungseinrichtung (26) zur Erfassung eines Spannungsabfalls über dem Messwiderstand.

## Claims

1. Resistor assembly (18) for a battery sensor (10) in a vehicle, comprising two line sections (20, 22) and a measuring resistor (24) arranged between the line sections (20, 22), wherein the measuring resistor (24) is electrically conductively connected to the line sections (20, 22) at contact areas (28, 30), **characterized in that** the contact areas (28, 30) are oblique with respect to the longitudinal axis (L) of the resistor assembly (18), such that the measuring resistor (24) is arranged obliquely with respect to the main current direction of the resistor assembly (18) that is defined by the longitudinal axis of the line sections or of the resistor assembly, **in that** at least one first contact point (32a, 32b) is provided at the first line section (20) and at least one second contact point (34a, 34b), which is associated with the first contact point (32a, 32b), is provided at the second line section (22), wherein the first contact point (32a, 32b) and the associated second contact point (34a, 34b) are arranged transversely with respect to the longitudinal direction (L) of the resistor assembly (18) in such a way that the influence of a temperature-induced change in the electrical resistance of the measuring resistor (24) and/or of the line sections (20, 22) is reduced and/or compensated for.

2. Resistor assembly according to Claim 1, **characterized in that** the contact areas (28, 30) are oblique with respect to the longitudinal axes of the line sections (20, 22).

3. Resistor assembly according to either of Claims 1 and 2, **characterized in that** the longitudinal axis of the measuring resistor (24) and the longitudinal axis of at least one line section (20, 22) coincide.

4. Resistor assembly according to one of the preceding claims, **characterized in that** the contact areas (28, 30) run essentially parallel to one another.

5. Resistor assembly according to one of the preceding claims, **characterized in that** a first contact point (32a, 32b) and a second contact point (34a, 34b), which is associated with the first contact point (32a, 32b), are arranged so as to be offset transversely with respect to the longitudinal direction (L) of the resistor assembly (18).

6. Resistor assembly according to one of the preceding claims, **characterized in that** at least two first contact points (32a, 32b) and at least two second contact points (34a, 34b) are provided, wherein one second contact point (34a, 34b) is associated with each first contact point (32a, 32b).

7. Resistor assembly according to Claim 6, **characterized in that** the positions of the first contact points (32a, 32b) and/or the second contact points (34a, 34b) transverse with respect to the longitudinal axis (L) of the resistor assembly (18) and/or the distance of the first contact points (32a, 32b) and/or the second contact points (34a, 34b) to the measuring resistor can vary.

8. Battery sensor (10) for detecting a battery current, comprising a resistor assembly (18) according to one of the preceding claims and comprising a detection apparatus (26) for detecting a voltage drop across the measuring resistor.

## Revendications

1. Module à résistance (18) destiné à un capteur de batterie (10) dans un véhicule, ledit module comprenant deux portions de ligne (20, 22) et une résistance de mesure (24) disposée entre les portions de ligne (20, 22), la résistance de mesure (24) étant reliée de manière électriquement conductrice aux portions de ligne (20, 22) au niveau de surfaces de contact (28, 30), **caractérisé en ce que** les surfaces de contact (28, 30) sont obliques par rapport à l'axe longitudinal (L) du module à résistance (18) de sorte que la résistance de mesure (24) soit disposée obliquement par rapport à la direction de courant principale du module à résistance (18) qui est définie par l'axe longitudinal des portions de ligne ou du module à résistance de sorte qu'au moins un premier point de contact (32a, 32b) est prévu sur la première portion de ligne (20) et au moins un deuxième point de contact (34a, 34b), associé au premier point de contact (32a, 32b), est prévu sur la deuxième portion de ligne (22), le premier point de contact (32a, 32b) et le deuxième point de contact associé (34a, 34b) étant disposés transversalement à la direction longitudinale (L) du module à résistance (18) de manière à réduire et/ou compenser l'influence d'une variation, due à la température, de la résistance électrique de la résistance de mesure (24) et/ou des portions de ligne (20, 22).

2. Module à résistance selon la revendication 1, **caractérisé en ce que** les surfaces de contact (28, 30) sont obliques par rapport aux axes longitudinaux des portions de ligne (20, 22).

3. Module à résistance selon l'une des revendications 1 et 2, **caractérisé en ce que** l'axe longitudinal de la résistance de mesure (24) et l'axe longitudinal d'au moins une portion de ligne (20, 22) coïncident.

4. Module à résistance selon l'une des revendications précédentes, **caractérisé en ce que** les surfaces de contact (28, 30) s'étendent sensiblement parallèlement entre elles.

5. Module à résistance selon l'une des revendications précédentes, **caractérisé en ce qu'**un premier point de contact (32a, 32b) et un deuxième point de contact (34a, 34b), associé au premier point de contact (32a, 32b), sont disposés de manière décalée transversalement à la direction longitudinale (L) du module à résistance (18).

6. Module à résistance selon l'une des revendications précédentes, **caractérisé en ce qu'**au moins deux premiers points de contact (32a, 32b) et au moins deux deuxièmes points de contact (34a, 34b) sont prévus, un deuxième point de contact (34a, 34b) étant associé à chaque premier point de contact (32a, 32b).

7. Module à résistance selon la revendication 6, **caractérisé en ce que** les positions des premiers points de contact (32a, 32b) et/ou des deuxièmes points de contact (34a, 34b) transversalement à l'axe longitudinal (L) du module à résistance (18) et/ou la distance des premiers points de contact (32a, 32b) et/ou des deuxièmes points de contact (34a, 34b) à la résistance de mesure peuvent varier.

8. Capteur de batterie (10) destiné à détecter un courant de batterie, ledit capteur de batterie comprenant un module à résistance (18) selon l'une des revendications précédentes et un dispositif de détection (26) destiné à détecter une chute de tension aux bornes de la résistance de mesure.
